# EUROPÄISCHE PATENTSCHRIFT

(11) **EP 4 139 696 B1**
(45) Veröffentlichungstag und Bekanntmachung des Hinweises auf die Patenterteilung: **12.11.2025**
(21) Anmeldenummer: 21719536.1
(22) Anmeldetag: 09.04.2021
(51) Int. Cl.: G01R 15/20, G01R 1/18

(54) **STROMSENSOREINHEIT**
CURRENT SENSOR UNIT
UNITÉ CAPTEUR DE COURANT

(30) Priorität: 20.04.2020 DE 102020002366
(43) Veröffentlichungstag der Anmeldung: 01.03.2023
(73) Patentinhaber: TDK-Micronas GmbH, 79108 Freiburg im Breisgau (DE)
(72) Erfinder: KIMMERLE, Achim, 79115 Freiburg (DE); KLAR, Lukas, 79110 Freiburg (DE)
(74) Vertreter: Koch Müller Patentanwaltsgesellschaft mbH
(86) Internationale Anmeldenummer: PCT/EP2021/000043
(87) Internationale Veröffentlichungsnummer: WO 2021/213698

(56) Entgegenhaltungen:
- WO-A1-2020/008844
- JP-A- 2015 135 288
- US-A1- 2019 293 733

## Beschreibung

Die Erfindung betrifft eine Stromsensoreinheit.

Ein berührungsloses Ermitteln der Stromstärke in einem stromdurchflossenen Kabel oder einer Schiene lässt sich mittels Messung der von dem Strom erzeugten magnetischen Flussdichte, nachfolgend auch als Zielfeld oder zu messenden Magnetfeld bezeichnet, durchführen. Vorzugsweise werden hierzu Magnetfeldsensoren wie TMR-, AMR-, GMR-, Flux-Gate- oder Hall-Sensoren eingesetzt. Die Magnetfelder von stromdurchflossenen Leitern sind auch bei Stromstärken mehreren Ampere nicht sehr groß gegenüber sogenannten "äußeren" Störfeldern wie beispielsweise dem Erdmagnetfeld, sodass eine präzise Messung eine Abschirmvorrichtung erfordert, ohne jedoch das Magnetfeld des stromdurchflossenen Leiters zu beeinflussen.

Zur Erhöhung des Messbereichs ist es folglich wichtig, möglichst nur den Einfluss der äußeren Magnetfelder auf den Magnetfeldsensor durch die Abschirmvorrichtung zu unterdrücken. Vorzugsweise umfasst hierzu die Abschirmvorrichtung das stromdurchflossene Kabel bzw. die Schiene und den Magnetfeldsensor zumindest teilweise.

Aus der DE 11 2013 005 763 T5 ist eine Stromsensoreinheit mit einem teilwelse U-förmigen Flusskonzentrator bekannt. Weitere Stromsensoreinheiten sich aus der DE 10 2012 221 803 A1, DE 10 2018 216 319 A1 und der DE 100 11 047 A1 bekannt. Weitere Stromsensoreinheiten sind aus US 2019 / 0293 733 A1, der WO 2020 / 008 844 A1 und der JP 2015 135 288 A bekannt.

Aus der EP 3 508 864 A1 ist eine Stromsensoreinheit mit einer stromführenden Schiene, einem an einer Kante der Schiene angeordneten Magnetfeldsensor und einer u-förmigen Abschirmvorrichtung bekannt, wobei die stromführende Schiene entlang eines Bodens der u-förmigen Abschirmvorrichtung verläuft und der Magnetfeldsensor auf der von dem Boden abgewandten Seite der stromführenden Schiene angeordnet ist.

Je nach Auslegung wirkt die umschließende Geometrie auch als Konzentrator und erhöht damit die Empfindlichkeit der gesamten Anordnung. Beispielsweise ist aus der DE 11 2013 005 763 T5 eine Vorrichtung mit einem Kernbereich bekannt, wobei der Kernbereich den Stromleiter bis auf einen Spalt umschließt und der Magnetfeldsensor innerhalb des Spalts angeordnet ist. Das Zielfeld, welches durch den Stromfluss verursacht wird, ist durch die geeignete Auslegung der Spaltgeometrie auf die Messvorrichtung fokussiert. Nachteilig ist, dass je nach Orientierung des Störfeldes auch das Störfeld in den Sensor gebündelt wird, so dass die schirmende Wirkung eine ungünstige Anisotropie aufweist.

Aus der DE 11 2012 002 744 T5 ist eine Stromsensoreinheit mit einem Sensorsubstrat mit magnetoelektrischem Wandler und einer magnetischen Abschirmung bekannt, wobei die magnetische Abschirmung das Sensorsubstrat und einen Abschnitt eines Stromleiters fast vollständig umschließt. In der Anordnung sind jedoch 2 u-förmige Abschirmvorrichtungen erforderlich, um eine ausreichend isotrope Wirkung zu erzielen. Gleichzeitig wird bei der Ausführung einer nahezu vollständigen Umschließung auch das Nutzfeld in die Abschirmung konzentriert und in der gezeigten Anordnung an dem Sensor vorbeigeführ. Hierdurch wird die Empfindlichkeit des Systems reduziert.

Vor diesem Hintergrund besteht die Aufgabe der Erfindung darin, eine Vorrichtung anzugeben, die den Stand der Technik weiterbildet.

Die Aufgabe wird durch eine Stromsensoreinheit mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Stromsensoreinheit bereitgestellt, aufweisend einen wenigstens teilweise plattenförmig ausgebildeten Stromleiter, beispielsweise in Form eines Shunts oder eines sogenannten Bus bzw. Busbars, sowie einen eine erste Magnetfeldkomponente messender Magnetfeldsensor.

Des Weiteren weist die Stromsensoreinheit eine u-förmige Abschirmung mit zwei parallel verlaufenden Seitenwänden und eine die beiden Seitenwände verbindende Rückwand auf.

Der Magnetfeldsensor ist zwischen den beiden Seitenwänden entlang einer in demselben Abstand zu jeder der beiden Seitenwände und senkrecht zu der Rückwand verlaufenden Mittelfläche angeordnet.

Außerdem ist der Stromleiter teilweise zwischen einer der beiden Seitenwände und dem Magnetfeldsensor angeordnet.

Die Abschirmung weist also einen u-förmigen Querschnitt auf und umschließt einen sich zwischen den Seitenwänden und der Rückwand erstreckenden Raum von drei Seiten.

Der Stromleiter durchläuft die Abschirmung, so dass sich zumindest ein Teilabschnitt des Stromleiters in dem von der Abschirmung umschlossenen Raum befindet.

Der Magnetfeldsensor ist innerhalb des von der Abschirmung umschlossenen Raums angeordnet.

Als Mittelfläche ist eine in demselben Abstand zu jeder der beiden Seitenwände und senkrecht zu der Rückwand verlaufende Fläche definiert, d.h. die Mittelfläche ist eine Symmetrieebene der u-förmigen Abschirmung.

Eine u-förmige Abschirmung ermöglicht es insbesondere senkrecht zu der Rückwand sowie senkrecht zu den Seitenwänden verlaufende Magnetfelder abzuschirmen. Als senkrechter Verlauf zu einer Wand, also Rück- oder Seitenwand, wird ein senkrecht zu einer Innen- oder Außenfläche der Wand bzw. parallel zu einer Flächennormalen der Wand verlaufende Richtung bezeichnet.

Eine Richtung senkrecht zu der Rückwand wird im Folgenden als x-Richtung bezeichnet, eine Richtung entlang einer Breite der Rückwand als y-Richtung und eine Richtung senkrecht zu den Seitenwänden als z-Richtung. Es versteht sich, dass die drei Raumrichtungen orthogonal zueinander ausgebildet sind. Auch sei angemerkt, dass der Magnetfeldsensor vorzugsweise sensitiv auf Magnetfeldkomponenten in x-Richtung ist.

Des Weiteren sei angemerkt, dass als Abschirmfaktor die Schwächung der Magnetfeldkomponente in x-Richtung, d.h. in einer sensitiven Richtung des Sensors, bezüglich der Stärke des Gesamtfeldes definiert wird. Anders ausgedrückt ist das der Quotient aus dem Betrag des Streufelds dividiert durch deren x-Komponente an dem Ort des Magnetfeldsensors.

Der Abschirmfaktor einer u-förmigen Abschirmung für in x- und z-Richtung verlaufende Magnetfelder weist mittig zwischen den beiden Seitenwänden entlang der x- Richtung einen Verlauf mit einem ausgeprägten Maximum in einem ersten Abstand zu der Rückwand der Abschirmung auf. Hierbei werden bereits in einem verhältnismäßig breiten Bereich, z. B. von einigen Millimetern, um das Maximum herum hohe Abschirmwerte erreicht.

Das Maximum ergibt sich aus einer maximalen Abschirmung von in x-Richtung verlaufenden Magnetfeldern in einem parallel zu der Rückwand und in einem Abstand oberhalb der Rückwand verlaufenden ersten Bereich sowie aus einer maximalen Abschirmung von in z-Richtung verlaufenden Magnetfeldern in einem mittig zwischen den Seitenwänden und senkrecht zu der Rückwand verlaufenden zweiten Bereich.

Bei den bekannten Anordnungen ist der Stromleiter entlang der Rückwand der u-förmigen Abschirmung angeordnet, wobei der oberhalb des Stromleiters angeordnete Magnetfeldsensor sich nicht mehr in dem idealen Bereich mit den maximalen Abschirmwerten anordnen lässt. Anders ausgedrückt, mit der Abschirmung nach dem Stand der Technik lassen sich magnetische Störfelder aus unterschiedlichen Störrichtungen nicht zuverlässig unterdrücken.

Die erfindungsgemäße Anordnung des Stromleiters entlang einer der Seitenwände ermöglicht es dagegen, den Sensor in dem Bereich des maximalen Abschirmfaktors der Abschirmung anzuordnen. Hierbei wird die anisotrope Wirkung der Abschirmung mit der Isotropie des Magnetfelssensors in geeigneter Weise kombiniert.

Eine Auslegung der Geometrie erfolgt durch Maximierung der Abschirmwirkung gegenüber einem äußeren Störfeld in der Vorzugsrichtung, d.h. in Orientierung des Sensorelements für eine maximale Sensitivität des Sensors.

Eine anisotrope Abschirmwirkung ist hinreichend, sofern das Sensorelement gegen die schlecht abgeschirmten Magnetfeldkomponenten unempfindlich d.h. nicht sensitiv oder nur sehr wenig sensitiv, ist. Im Allgemeinen stehen die schlecht abgeschirmten Magnetfeldkomponenten orthogonal zu der Vorzugsrichtung.

Durch den an einer Seite vollständig offenen u-förmigen Querschnitt der Abschirmung ist nicht nur die Montage, z.B. durch Aufstecken, besonders einfach möglich.

Zusätzlich verringert die relativ weite Öffnung des u-förmigen Querschnitts die Einkopplung der Abschirmung in das Nutzsignal im Vergleich zu einer Abschirmung mit fast geschlossenem Querschnitt, also einer den Stromleiter fast vollständig umschließenden bzw. umlaufenden Abschirmvorrichtung.

Hierdurch lassen sich insbesondere die Wandstärke und Material und Kosten reduzieren, ohne dass Sättigungseffekte in der Abschirmung auftreten.

In einer ersten Ausführungsform weist der Magnetfeldsensor zu der Rückwand einen Abstand von mindestens 1 mm oder mindestens 3 mm oder von mindestens 5 mm und von höchstens 10 mm oder höchstens 7 mm oder höchstens 5 mm auf.

Der Abstand berücksichtigt, dass die u-förmige Abschirmung den höchsten Abschirmungsfaktor nicht direkt an oder über der Innenfläche der Rückwand, sondern in einem Abstand zu der Rückwand jedoch noch näher an der Rückwand als an der gegenüberliegenden offenen Seite aufweist.

In einer weiteren Ausführungsform weist der Magnetfeldsensor zu der Mittelfläche einen Abstand von höchstens 5 mm oder höchstens 2 mm oder höchstens 1 mm oder von höchstens 0,1 mm auf. Eine besonders gute Abschirmung von senkrecht zu den Seitenwänden verlaufenden äußeren Magnetfeldern wird mittig zwischen den Seitenwänden, also insbesondere im Bereich der Mittelfläche erreicht. Mit einem möglichst geringen Abstand zu der Mittelfläche wird somit eine besonders gute Unterdrückung der magnetischen Streufelder erzielt.

In einer anderen Ausführungsform ist eine Höhe der Seitenwände über der Rückwand größer als ein Abstand zwischen den beiden Seitenwänden. Beispielsweise ist die Höhe um einen Faktor von 1,5 oder von 2,5 größer als der Abstand. Die Tiefe der u-Form ist also größer als eine Breite der u-Form, wodurch sich das Maxima des Abschirmfaktors der Abschirmung erhöht und die Position des Maximums verschoben wird.

In einer weiteren Ausführungsform beträgt eine Wandstärke der Abschirmung mindestens 0,1 mm oder mindestens 1 mm oder mindestens 2 mm oder mindestens 3 mm. Eine geringe Wandstärke ermöglicht dank geringem Materialverbrauchs eine kostengünstige Herstellung. Jedoch sollten Sättigungseffekte innerhalb der Abschirmwände vermieden werden.

Durch die einseitig offene Form der u-förmigen Abschirmung ist die Einkopplung äußerer Felder nicht besonders stark ausgeprägt, so dass eine mittlere Wandstärke typischer Weise ausreicht, um Sättigungseffekte zuverlässig auszuschließen.

In einer anderen Weiterbildung weisen die Rückwand und / oder die beiden Seitenwände eine quadratische Außenfläche auf.

In einer weiteren Weiterbildung weisen die Seitenwände zueinander einen Abstand von mindestens 10 mm oder von mindestens 15 mm auf.

In einer anderen Ausführungsform beträgt eine Höhe der Seitenwände über der Rückwand mindestens 20 mm oder mindestens 25 mm oder mindestens 30 mm.

In einer weiteren Ausführungsform besteht die Abschirmung aus einen ferromagnetischen Material oder weist ein ferromagnetisches Material auf. Beispielsweise besteht die Abschirmung aus SiFe oder NiFe oder einem µ-Metall, auch als Mu-Metall bezeichnet, oder weist SiFe oder NiFe oder ein µ-Metall auf.

In einer anderen Weiterbildung umfasst der Magnetfeldsensor einen Hallsensor oder einen TMR- Sensor oder einen AMR-Sensor oder einen GMR-Sensor.

In einer weiteren Weiterbildung ist der Magnetfeldsensor auf einer Leiterplatte angeordnet und die Leiterplatte ist auf einer dem Stromleiter zugewandten oder abgewandten Seite des Magnetfeldsensors angeordnet.

In einer weiteren Ausführungsform beträgt eine Länge der Seitenwände entlang der Rückwand mindestens 10 mm oder von mindestens 15 mm oder mindestens 20 mm.

In einer anderen Ausführungsform ist der Stromleiter dazu ausgelegt, dass ein Strom entlang einer Längsachse des Stromleiters fließt, wobei die Längsachse des Stromleiters senkrecht zu einem Abstand zwischen den beiden Seitenwänden der Abschirmung verläuft. Die Stromrichtung verläuft also senkrecht zu den Flächennormalen der Seitenwände.

Außerdem verläuft die Stromrichtung beispielsweise parallel zu der Rückwand bzw. senkrecht zu einer Flächennormale auf der Rückwand. Anders ausgedrückt, verläuft die Stromrichtung senkrecht zu dem u-förmigen Querschnitt der Abschirmung.

In einer weiteren Weiterbildung ist der Stromleiter als Shunt ausgebildet, wobei der Stromleiter eine Längsachse und einen rechteckigen Querschnitt senkrecht zu einer Längsachse aufweist und eine Haupterstreckungsfläche entlang der Längsachse parallel zu der Seitenwand angeordnet ist.

Aufgrund des rechteckigen Querschnitts weist der Stromleiter zwei schmale und zwei breite Seitenflächen auf, wobei die breiten Seitenflächen-als Haupterstreckungsfläche bezeichnet werden.

In einer weiteren Ausführungsform ist der Magnetfeldsensor dazu ausgelegt, eine entlang einer Messrichtung verlaufende Magnetfeldkomponente zu detektieren, wobei der Magnetfeldsensor so angeordnet ist, dass die Messrichtung senkrecht zu der Rückwand der Abschirmung verläuft und zu einer mittig zwischen den beiden Seitenwänden verlaufenden Mittelfläche einen Abstand von höchstens 5mm oder höchstens 2 mm oder höchstens 1 mm aufweist.

Die Anordnung erlaubt eine gewisse Toleranz hinsichtlich einer Anordnung des Magnetfeldsensors zwischen den Seitenwänden, also einen gewissen Abstand von einer mittigen Anordnung bzw. einer Anordnung entlang der Mittelebene.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine perspektivische Ansicht einer ersten Ausführungsform einer Stromsensoreinheit,
- Figur 2: einen Querschnitt einer zweiten Ausführungsform der Stromsensoreinheit,
- Figur 3: einen Querschnitt einer dritten Ausführungsform der Stromsensoreinheit,
- Figur 4: einen Magnetfeldverlauf innerhalb einer u-förmigen Abschirmung für ein erstes äußeres Magnetfeld,
- Figur 5: einen Magnetfeldverlauf innerhalb einer u-förmigen Abschirmung für ein zweites äußeres Magnetfeld,
- Figur 6: einen Verlauf eines Abschirmfaktors für eine u-förmige Abschirmung.

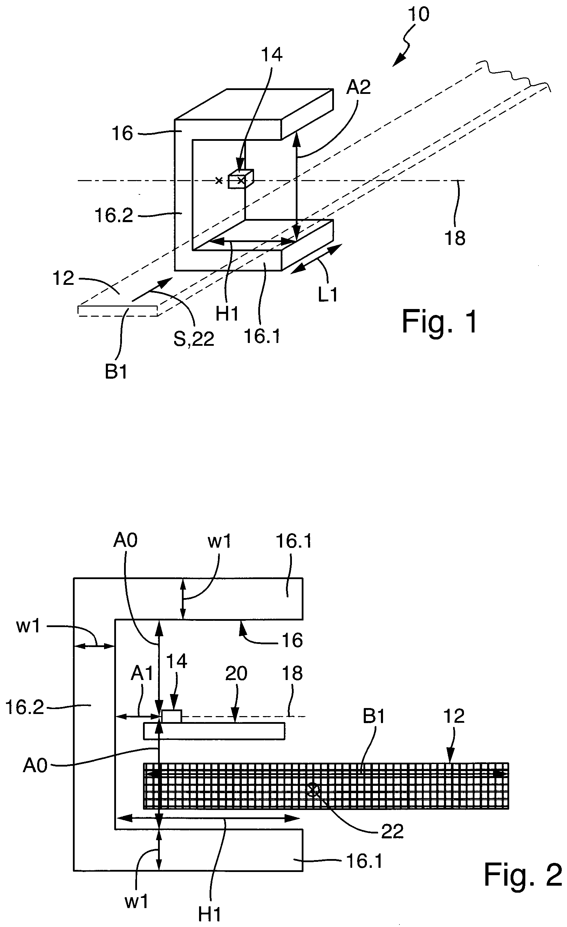

Die Abbildung der Figur 1 zeigt eine perspektivische Ansicht einer ersten Ausführungsform einer Stromsensoreinheit 10, aufweisend einen plattenförmig ausgebildeten Stromleiter 12, einen eine erste Magnetfeldkomponente messenden Magnetfeldsensor und eine u-förmige Abschirmung mit zwei parallel verlaufenden Seitenwänden 16.1 und einer die beiden Seitenwände 16.1 verbindenden Rückwand 16.2.

Die Seitenwände 16.1 der Abschirmung 16 weisen einen Abstand A2 zueinander, über der Rückwand 16.2 eine Höhe H1 und entlang der Rückwand 16.2 eine Länge L1 auf.

Der Magnetfeldsensor 14 ist in einem Abstand zu der Rückwand 16.1 mittig zwischen den beiden Seitenwänden 16.1 angeordnet, so dass eine durch einen Pfeil in dem Magnetfeldsensor 14 angedeutete Messrichtung des Magnetfeldsensors 14 entlang einer senkrecht auf der Rückwand stehenden Geraden 18 verläuft. Der Magnetfeldsensor weist also denselben Abstand zu jeder der beiden Seitenwände 16.1 auf.

Die Abschirmung 16 ist so um den Stromleiter 12 angeordnet, dass ein Abschnitt des Stromleiters 12 zwischen dem Magnetfeldsensor 14 und einer der beiden Seitenwände 16.1 angeordnet ist. Der Stromleiter 12 weist einen rechteckigen Querschnitt und entsprechend zwei breite Seitenflächen mit einer Breite B1 und zwei schmale Seitenflächen auf, wobei die breiten Seitenflächen parallel zu den Seitenwänden 16.1 der Abschirmung 16 verlaufen und die Breite B1 des Stromleiters 12 geringer als die Höhe H1 der Seitenwände 16.1 Abschirmung 16 ist.

Eine Stromrichtung S verläuft entlang bzw. parallel zu einer senkrecht zum Querschnitt verlaufenden Längsachse 22 des Stromleiters 12.

In der Abbildung der Figur 2 ist eine weitere Ausführungsform dargestellt. Im Folgenden werden nur die Unterschiede zu der Abbildung der Figur 1 erläutert.

Der Magnetfeldsensor 14 ist auf einer Leiterplatte 20 angeordnet, wobei die Leiterplatte so zwischen dem Magnetfeldsensor 14 und dem Stromleiter 12 angeordnet ist, dass der Magnetfeldsensor 14 zu jeder der beiden Seitenwände 16.1 der Abschirmung 16 denselben Abstand A0 und zu der Rückwand den Abstand A1 aufweist.

Die Abschirmung weist eine Wandstärke W1 auf. Die Höhe H1 der Seitenwände 16.1 über der Rückwand 16.2 ist geringer als die Breite B1 des Stromleiters 12. Die Längsachse 22 des Stromleiters 12 verläuft parallel zu den Seitenwänden 16.1 und der Rückwand 16.2 der Abschirmung 16 bzw. senkrecht zu den Flächennormalen der Wände der Abschirmung 16.

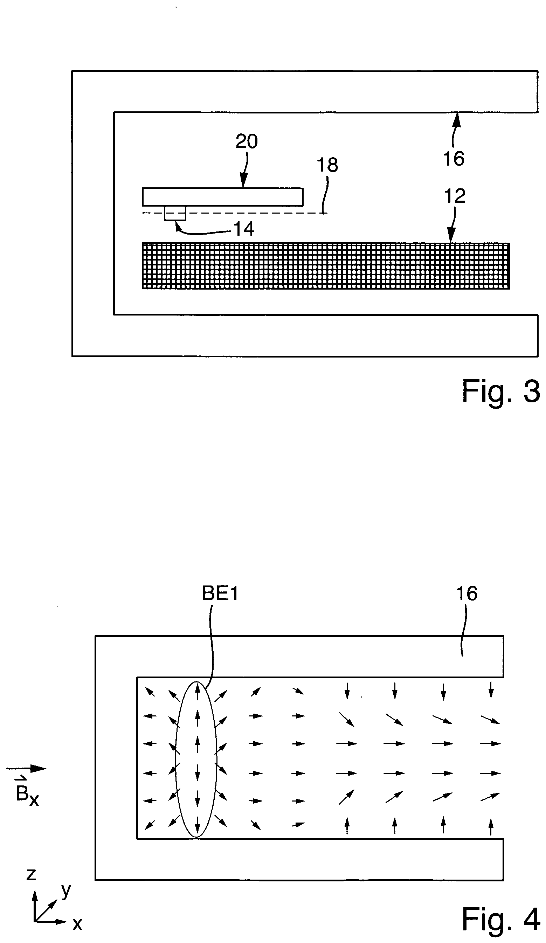

In der Abbildung der Figur 3 ist eine weitere Ausführungsform dargestellt. Im Folgenden werden nur die Unterschiede zu den Abbildungen der Figuren 1 und 2 erläutert.

Die Leiterplatte 20 ist an einer dem Stromleiter 12 abgewandten Seite des Magnetfeldsensors 14 angeordnet.

In der Abbildung der Figur 4 ist ein Magnetfeldverlauf innerhalb einer u-förmigen Abschirmung 16 für ein erstes äußeres Magnetfeld schematisch dargestellt.

Das erste äußere Magnetfeld Bₓ verläuft parallel zu einer x-Richtung, wobei die x-Richtung senkrecht zu der Rückwand 16.2 und parallel zu den Seitenwänden 16.1 verläuft.

Innerhalb der Abschirmung 16 bildet sich parallel zu der Rückwand ein erster Bereich BE1 aus, wobei in dem ersten Bereich BE1 nur in z-Richtung verlaufende Magnetfeldkomponenten, aber keine Magnetfeldkomponenten in x-Richtung auftreten. In dem ersten Bereich BE1 verursacht das erste äußere Magnetfeld somit kein von dem Magnetfeldsensor 14 erfassbares Feld.

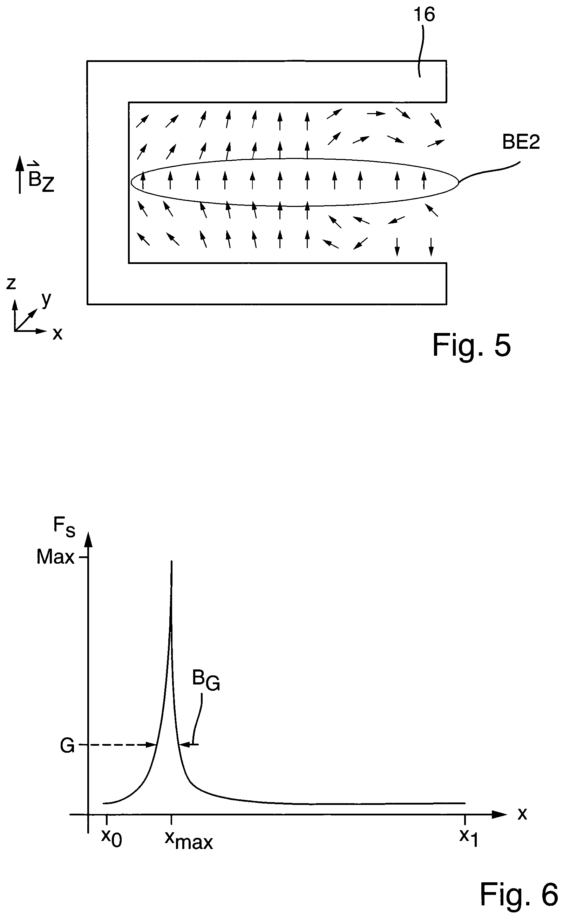

In der Abbildung der Figur 5 ist ein Magnetfeldverlauf innerhalb der u-förmigen Abschirmung 16 für ein zweites äußeres Magnetfeld schematisch dargestellt.

Das zweite äußere Magnetfeld B_{z} verläuft parallel zu einer z-Richtung, wobei die z-Richtung parallel zu der Rückwand 16.2 und senkrecht zu den Seitenwänden 16.1 verläuft.

Innerhalb der Abschirmung 16 bildet sich parallel zu den Seitenwänden und mittig zwischen den Seitenwänden ein zweiter Bereich BE2 aus, wobei in dem zweiten Bereich BE2 nur in z-Richtung verlaufende Magnetfeldkomponenten und keine in x-Richtung verlaufende Komponenten auftreten. In dem zweiten Bereich BE2 verursacht das erste äußere Magnetfeld somit kein von dem Magnetfeldsensor 14 erfassbares Feld.

In der Abbildung der Figur 6 ist der Verlauf eines Abschirmfaktors Fₛ entlang einer senkrecht zu der Rückwand 16.2 mittig zwischen den beiden Seitenwänden 16.1 verlaufenden Geraden schematisch dargestellt, wie er sich aus den in den Figuren 4 und 5 dargestellten Feldverläufen innerhalb der u-förmigen Abschirmung ergibt.

Zwischen der Rückwand 16.2 an einer Position x₀ und einem Ende der Seitenwände an einer Position x₁ weist der Verlauf einen Peak bzw. Scheitelpunkt mit einem maximalen Wert Max bei einer Position xₘₐₓ auf. In einem Abstand von |xₘₐₓ-x₀| von der Rückwand 16.2 und in einem gleichen Abstand zu den Seitenwänden 16.1 wird somit ein besonders hoher Abschirmfaktor, also eine besonders gute Abschirmung erreicht.

Geht man von einem Grenzwert G für den Abschirmfaktor Fₛ aus, wobei der Grenzwert G eine zu tolerierende Untergrenze für den Abschirmfaktor Fₛ angibt, so ergibt sich aus dem dargestellten Verlauf ein Toleranzbereich um die Position xₘₐₓ mit einer Breite B_{G}, wobei an allen Positionen innerhalb des Toleranzbereichs zumindest die tolerierbare Abschirmung erreicht wird.

## Patentansprüche

1. Stromsensoreinheit (10)ausgebildet, um die Abschirmwirkung gegenüber einem äußeren Störfeld in einer Vorzugsrichtung für die das Sensorelement eine maximale Sensitivität aufweist, zu erhöhen, aufweisend
- einen wenigstens teilweise plattenförmig ausgebildeten Stromleiter (12),
- einen eine erste Magnetfeldkomponente messender Magnetfeldsensor (14) und
- eine u-förmige Abschirmung (16) mit zwei parallel verlaufenden Seitenwänden (16.1) und einer die beiden Seitenwände (16.1) verbindenden Rückwand (16.2), wobei der Bereich zwischen den parallel verlaufenden Seitenwänden (16.1) bei Exposition eines äußeren Magnetfeldes mit einer Orientierung parallel zu den beiden Seitenwänden einen Bereich (BE1) aufweist, in dem die Magnetfeldkomponente parallel zu den beiden Seitenwänden (16.1) einen Minimumbetrag annimmt,
- der Magnetfeldsensor (14) entlang einer in demselben Abstand (A0) zu jeder der beiden Seitenwände (16.1) und senkrecht zu der Rückwand (16.2) verlaufenden Mittelfläche zwischen den beiden Seitenwänden (16.1) angeordnet ist und
- der Stromleiter (12) zumindest teilweise zwischen einer der beiden Seitenwände (16.1) und dem Magnetfeldsensor (14) angeordnet ist, der Magnetfeldsensor (14) dazu ausgelegt ist, eine entlang einer Messrichtung (R1) verlaufende Magnetfeldkomponente zu detektieren und der Magnetfeldsensor (14) so angeordnet ist, dass die Messrichtung (R1) senkrecht zu der Rückwand (16.2) der Abschirmung (16) verläuft
**dadurch gekennzeichnet, dass**
der Magnetfeldsensor (14) in dem Bereich (BE1) angeordnet ist, in dem die Magnetfeldkomponente parallel zu den beiden Seitenwänden den Minimumbetrag annimmt.

2. Stromsensoreinheit (10) nach Anspruch 1, **dadurch gekennzeichnet, dass** der Magnetfeldsensor (14) zu der Rückwand (16.2) einen Abstand (A1) von mindestens 1 mm oder mindestens3 mm oder von mindestens 5 mm und von höchstens 10 mm oder höchstens 7 mm oder höchstens 5 mm aufweist.

3. Stromsensoreinheit (10) nach Anspruch 1 oder 2, **dadurch gekennzeichnet, dass** der Magnetfeldsensor (14) zu der Mittelfläche einen Abstand von höchstens 1 mm oder von höchstens 0,1 mm aufweist.

4. Stromsensoreinheit (10) nach einem der vorstehenden Ansprüche, **dadurch gekennzeichnet, dass** eine Höhe (H1) der Seitenwände (16.1) über der Rückwand (16.2) größer als ein Abstand (A2) zwischen den beiden Seitenwänden (16.1) ist.

5. Stromsensoreinheit (10) nach einem der vorstehenden Ansprüche, **dadurch gekennzeichnet, dass** eine Wandstärke (W1) der Abschirmung (16) mindestens 0,1 mm oder mindestens 1 mm oder mindestens 2 mm oder mindestens 3 mm beträgt.

6. Stromsensoreinheit (10) nach einem der vorstehenden Ansprüche, **dadurch gekennzeichnet, dass** die Rückwand (16.2) und / oder die beiden Seitenwände (16.2) eine quadratische Außenfläche aufweisen.

7. Stromsensoreinheit (10) nach einem der vorstehenden Ansprüche, **dadurch gekennzeichnet, dass** die Seitenwände (16.1) zueinander einen Abstand (A2) von mindestens 10 mm oder von mindestens 15 mm aufweisen.

8. Stromsensoreinheit (10) nach einem der vorstehenden Ansprüche, **dadurch gekennzeichnet, dass** eine Höhe (H1) der Seitenwände (16.1) über der Rückwand (16.2) mindestens 20 mm oder mindestens 25 mm oder mindestens 30 mm beträgt.

9. Stromsensoreinheit (10) nach einem der vorstehenden Ansprüche, **dadurch gekennzeichnet, dass** die Abschirmung (16) aus einen ferromagnetischen Material besteht oder ein ferromagnetisches Material aufweist.

10. Stromsensoreinheit (10) nach einem der vorstehenden Ansprüche, **dadurch gekennzeichnet, dass** der Magnetfeldsensor (14) einen Hallsensor oder einen TMR- Sensor oder einen AMR-Sensor oder einen GMR-Sensor umfasst.

11. Stromsensoreinheit (10) nach einem der vorstehenden Ansprüche, **dadurch gekennzeichnet, dass** der Magnetfeldsensor (14) auf einer Leiterplatte (20) angeordnet ist und die Leiterplatte (20) auf einer dem Stromleiter (12) zugewandten oder abgewandten Seite des Magnetfeldsensors (14) angeordnet ist.

12. Stromsensoreinheit (10) nach einem der vorstehenden Ansprüche, **dadurch gekennzeichnet, dass** eine Länge der Seitenwände entlang der Rückwand mindestens 10 mm oder von mindestens 15 mm oder mindestens 20 mm beträgt.

13. Stromsensoreinheit (10) nach einem der vorstehenden Ansprüche, **dadurch gekennzeichnet, dass** der Stromleiter (12) dazu ausgelegt ist, dass ein Strom entlang einer Längsachse (22) des Stromleiters (12) fließt, wobei die Längsachse (22) des Stromleiters (12) senkrecht zu einem Abstand (A2) zwischen den beiden Seitenwänden (16.1) der Abschirmung (16) verläuft.

14. Stromsensoreinheit (10) nach einem der vorstehenden Ansprüche, **dadurch gekennzeichnet, dass** der Stromleiter (12) als Shunt ausgebildet ist, eine Längsachse und einen rechteckigen Querschnitt senkrecht zu einer Längsachse aufweist, wobei eine Haupterstreckungsfläche entlang der Längsachse parallel zu der Seitenwand angeordnet ist.

15. Stromsensoreinheit (10) nach einem der vorstehenden Ansprüche, **dadurch gekennzeichnet, dass** der Magnetfeldsensor (14) zu einer mittig zwischen den beiden Seitenwänden (16.1) verlaufenden Mittelfläche einen Abstand von höchstens 2 mm aufweist.

## Claims

1. Current sensor unit (10) constructed for increasing the screening effect relative to an external disturbance field in a preferential direction for which the sensor element has a maximum sensitivity, comprising:
- a current conductor (12) formed to be plate-shaped at least in part,
- a magnetic field sensor (14) measuring a first magnetic field component and
- a U-shaped screen (16) with two parallelly extending side walls (16.1) and a back wall (16.2) connecting the two side walls (16.1), wherein the region between the parallelly extending side walls (16.1) in the case of exposure to an external magnetic field with an orientation parallel to the two side walls has a region (BE1) in which the magnetic field component adopts a minimum amount parallel to the two side walls (16.1),
- the magnetic field sensor (14) is arranged along a middle surface, which extends at the same spacing (A0) from each of the two side walls (16.1) and perpendicularly to the back wall (16.2), between the two side walls (16.1) and
- the current conductor (12) is arranged at least partly between one of the two side walls (16.1) and the magnetic field sensor (14), the magnetic field sensor (14) is designed for the purpose of detecting a magnetic field component running in a measuring direction (R1) and the magnetic field sensor (14) is so arranged that the measuring direction (R1) extends perpendicularly to the back wall (16.2) of the screen (16),
**characterised in that**
the magnetic field sensor (14) is arranged in the region (BE1) in which the magnetic field component adopts the minimum amount parallel to the two side walls.

2. Current sensor unit (10) according to claim 1, **characterised in that** the magnetic field sensor (14) has from the back wall (16.2) a spacing (A1) of at least 1 mm or at least 3 mm or at least 5 mm and at most 10 mm or at most 7 mm or at most 5 mm.

3. Current sensor unit (10) according to claim 1 or 2, **characterised in that** the magnetic field sensor (14) has from the middle surface a spacing of at most 1 mm or at most 0.1 mm.

4. Current sensor unit (10) according to any one of the preceding claims, **characterised in that** a height (H1) of the side walls (16.1) above the back wall (16.2) is greater than a spacing (A2) between the two side walls (16.1).

5. Current sensor unit (10) according to any one of the preceding claims, **characterised in that** a wall thickness (W1) of the screen (16) is at least 0.1 mm or at least 1 mm or at least 2 mm or at least 3 mm.

6. Current sensor unit (10) according to any one of the preceding claims, **characterised in that** the back wall (16.2) and/or the two side walls (16.2) has or have a square outer surface.

7. Current sensor unit (10) according to any one of the preceding claims, **characterised in that** the side walls (16.1) have from one another a spacing (A2) of at least 10 mm or at least 15 mm.

8. Current sensor unit (10) according to any one of the preceding claims, **characterised in that** a height (H1) of the side walls (16.1) above the back wall (16.2) is at least 20 mm or at least 25 mm or at least 30 mm.

9. Current sensor unit (10) according to any one of the preceding claims, **characterised in that** the screen (16) consists of a ferromagnetic material or comprises a ferromagnetic material.

10. Current sensor unit (10) according to any one of the preceding claims, **characterised in that** the magnetic field sensor (14) comprises a Hall sensor or a TMR sensor or an AMR sensor or a GMR sensor.

11. Current sensor unit (10) according to any one of the preceding claims, **characterised in that** the magnetic field sensor (14) is arranged on a circuitboard (20) and the circuitboard (20) is arranged on a side of the magnetic field sensor (14) facing towards or away from the current conductor (12).

12. Current sensor unit (10) according to any one of the preceding claims, **characterised in that** a length of the side walls along the back wall is at least 10 mm or at least 15 mm or at least 20 mm.

13. Current sensor unit (10) according to any one of the preceding claims, **characterised in that** the current conductor (12) is designed so that a current flows along a longitudinal axis (22) of the current conductor (12), wherein the longitudinal axis (22) of the current conductor (12) extends perpendicularly to a spacing (A2) between the two side walls (16.1) of the screen (16).

14. Current sensor unit (10) according to any one of the preceding claims, **characterised in that** the current conductor (12) is constructed as a shunt, and has a longitudinal axis and a rectangular cross-section perpendicular to a longitudinal axis, wherein a principal dimension area is arranged along the longitudinal axis parallel to the side wall.

15. Current sensor unit (10) according to any one of the preceding claims, **characterised in that** the magnetic field sensor (14) has a spacing of at most 2 mm from a middle surface extending between the two side walls (16.1).

## Revendications

1. Unité capteur de courant (10) conçue pour augmenter l'effet de blindage contre un champ parasite externe dans une direction préférentielle sur laquelle l'élément capteur présente une sensibilité maximale, comprenant
- un conducteur de courant (12) au moins partiellement en forme de plaque,
- un capteur de champ magnétique (14) mesurant une première composante du champ magnétique et
- un blindage en forme de U (16) avec deux parois latérales parallèles (16.1) et une paroi arrière (16.2) reliant les deux parois latérales (16.1), la zone entre les parois latérales parallèles (16.1) présentant, en cas d'exposition à un champ magnétique extérieur ayant une orientation parallèle aux deux parois latérales, une zone (BE1) dans laquelle la composante du champ magnétique parallèle aux deux parois latérales (16.1) prend une valeur minimale,
- le capteur de champ magnétique (14) est disposé entre les deux parois latérales (16.1) le long d'une surface médiane s'étendant à la même distance (A0) de chacune des deux parois latérales (16.1) et perpendiculairement à la paroi arrière (16.2), et
- le conducteur de courant (12) est disposé au moins partiellement entre l'une des deux parois latérales (16.1) et le capteur de champ magnétique (14), le capteur de champ magnétique (14) est conçu pour détecter une composante du champ magnétique s'étendant le long d'une direction de mesure (R1) et le capteur de champ magnétique (14) est disposé de telle sorte que la direction de mesure (R1) soit perpendiculaire à la paroi arrière (16.2) du blindage (16)
**caractérisé en ce que**
le capteur de champ magnétique (14) est disposé dans la zone (BE1) dans laquelle la composante du champ magnétique parallèle aux deux parois latérales prend sa valeur minimale.

2. Unité capteur de courant (10) selon la revendication 1, **caractérisée en ce que** le capteur de champ magnétique (14) présente une distance (A1) par rapport à la paroi arrière (16.2) d'au moins 1 mm ou d'au moins 3 mm ou d'au moins 5 mm et d'au plus 10 mm ou d'au plus 7 mm ou d'au plus 5 mm.

3. Unité capteur de courant (10) selon la revendication 1 ou 2, **caractérisée en ce que** le capteur de champ magnétique (14) présente une distance maximale de 1 mm ou de 0,1 mm par rapport à la surface médiane.

4. Unité capteur de courant (10) selon l'une des revendications précédentes, **caractérisée en ce qu'**une hauteur (H1) des parois latérales (16.1) au-dessus de la paroi arrière (16.2) est supérieure à une distance (A2) entre les deux parois latérales (16.1).

5. Unité capteur de courant (10) selon l'une des revendications précédentes, **caractérisée en ce qu'**une épaisseur (W1) de la paroi de blindage (16) est d'au moins 0,1 mm ou d'au moins 1 mm ou d'au moins 2 mm ou d'au moins 3 mm.

6. Unité capteur de courant (10) selon l'une des revendications précédentes, **caractérisée en ce que** la paroi arrière (16.2) et/ou les deux parois latérales (16.2) présentent une surface extérieure carrée.

7. Unité capteur de courant (10) selon l'une des revendications précédentes, **caractérisée en ce que** les parois latérales (16.1) présentent entre elles un écart (A2) d'au moins 10 mm ou d'au moins 15 mm.

8. Unité capteur de courant (10) selon l'une des revendications précédentes, **caractérisée en ce que** la hauteur (H1) des parois latérales (16.1) au-dessus de la paroi arrière (16.2) est d'au moins 20 mm ou d'au moins 25 mm ou d'au moins 30 mm.

9. Unité capteur de courant (10) selon l'une des revendications précédentes, **caractérisée en ce que** le blindage (16) est constitué d'un matériau ferromagnétique ou comporte un matériau ferromagnétique.

10. Unité capteur de courant (10) selon l'une des revendications précédentes, **caractérisée en ce que** le capteur de champ magnétique (14) comprend un capteur à effet Hall ou un capteur TMR ou un capteur AMR ou un capteur GMR.

11. Unité capteur de courant (10) selon l'une des revendications précédentes, **caractérisée en ce que** le capteur de champ magnétique (14) est disposé sur une carte de circuit imprimé (20) et la carte de circuit imprimé (20) est disposée sur un côté du capteur de champ magnétique (14) tourné vers ou détourné du conducteur de courant (12).

12. Unité capteur de courant (10) selon l'une des revendications précédentes, **caractérisé en ce qu'**une longueur des parois latérales le long de la paroi arrière est d'au moins 10 mm, d'au moins 15 mm ou d'au moins 20 mm.

13. Unité capteur de courant (10) selon l'une des revendications précédentes, **caractérisée en ce que** le conducteur de courant (12) est conçu de telle sorte qu'un courant circule le long d'un axe longitudinal (22) du conducteur de courant (12), l'axe longitudinal (22) du conducteur de courant (12) étant perpendiculaire à une distance (A2) entre les deux parois latérales (16.1) du blindage (16).

14. Unité capteur de courant (10) selon l'une des revendications précédentes, **caractérisée en ce que** le conducteur de courant (12) est conçu comme un shunt, présente un axe longitudinal et une section transversale rectangulaire perpendiculaire à un axe longitudinal, une surface d'extension principale étant disposée le long de l'axe longitudinal parallèlement à la paroi latérale.

15. Unité capteur de courant (10) selon l'une des revendications précédentes, **caractérisée en ce que** le capteur de champ magnétique (14) présente une distance maximale de 2 mm par rapport à une surface centrale s'étendant entre les deux parois latérales (16.1).
